# EUROPEAN PATENT SPECIFICATION

(11) **EP 2 845 221 B1**
(45) Date of publication and mention of the grant of the patent: **20.09.2017**
(21) Application number: 13784423.9
(22) Date of filing: 06.05.2013
(51) Int. Cl.: H01L 21/304

(54) **CMP CONDITIONER PADS WITH SUPERABRASIVE GRIT ENHANCEMENT**
KISSEN FÜR CHEMISCH-MECHANISCHES POLIEREN MIT HOCHABRASIVER KÖRNERVERSTÄRKUNG
TAMPONS DE CONDITIONNEUR DE POLISSAGE CHIMICOMÉCANIQUE (CMP) AVEC AMÉLIORATION DE MATIÈRE SUPERABRASIVE

(30) Priority: 04.05.2012 US 201261642874 P
(43) Date of publication of application: 11.03.2015
(73) Proprietor: Entegris, Inc., Billerica, MA 01821 (US)
(72) Inventor: DOERING, Patrick, Holliston, MA 01746 (US); GALPIN, Andrew, Westford, Massachusetts 01886 (US)
(74) Representative: adares Patent- und Rechtsanwälte Reininger & Partner GmbB
(86) International application number: PCT/US2013/039771
(87) International publication number: WO 2013/166516

(56) References cited:
- KR-A- 20090 106 214
- KR-A- 20120 026 709
- US-A- 6 054 183
- US-A1- 2008 053 000
- US-A1- 2009 042 494
- US-A1- 2011 250 826

## Description

### FIELD OF THE INVENTION

The disclosure is directed generally to semiconductor manufacturing equipment. More specifically, the disclosure is directed to conditioning devices for the cleaning of polishing pads used in the manufacture of semiconductors.

### BACKGROUND

Chemical mechanical planarization (CMP) is used extensively in the manufacture of semiconductor chips and memory devices. During a CMP process, material is removed from a wafer substrate by the action of a polishing pad, a polishing slurry, and optionally chemical reagents. Over time, the polishing pad becomes matted and filled with debris from the CMP process. Periodically the polishing pad is reconditioned using a pad conditioner that abrades the polishing pad surface and opens pores and creates asperities on the surfaces of the polishing pad. The function of the pad conditioner is to maintain the removal rate in the CMP process.

CMP represents a major production cost in the manufacture of semiconductor and memory devices. These CMP costs include those associated with polishing pads, polishing slurries, pad conditioning disks and a variety of CMP parts that become worn during the planarizing and polishing operations. Additional cost for the CMP process includes tool downtime in order to replace the polishing pad and the cost of the test wafers to recalibrate the CMP polishing pad.

A typical polishing pad comprises closed-cell polyurethane foam with a thickness in the range of approximately 0.15 to .20 centimeters thick. During pad conditioning, the pads are subjected to mechanical abrasion in order to physically cut through the cellular layers of the pad surface. The exposed surface of the pad contains open cells, which can be used during the CMP process to trap abrasive slurry consisting of the spent polishing slurry and material removed from the wafer. The pad conditioner removes the outer layer of cells containing the embedded materials and minimizes removal of layers below the outer layer. Over-texturing of the polishing pad results in a shortened life, while under-texturing results in insufficient material removal rate and lack of wafer uniformity during the CMP step.

Certain pad conditioners utilize superabrasive particles such as diamond that are adhered to a substrate. See, e.g., U.S. Patent Application Publication No. 2009/042494 to Moon et al. (Moon) (disclosing a pad conditioner having a substrate constructed of a flat plate or disk shape, a coating part formed on the substrate and plurality of protrusion parts formed on the coating part and having a plurality of poslishing members such as diamond particles), U.S. Patent No. 7,201,645 to Sung (Sung) (disclosing a contoured CMP pad dresser that has a plurality of superabrasive particles attached to the substrate); U.S. Patent Application Publication No. 2006/0128288 to An et al. (An) (disclosing a layer of metal binder fixing the abrasive particles to a metal substrate, with a diameter difference between smaller and bigger abrasive particles ranging from 10% to 40%). A problem with prior art pad conditioners is that the forces generated on the proudest features of the pad conditioners can result in the particles that experience the higher forces to become dislodged from the pad conditioner. Dislodged particles can be captured by the polishing pad which can lead to scratching of the wafers during the polishing operation.

There is a continuing need for CMP pad dressers that reduce or eliminate abrasive particles becoming dislodged and CMP pad dressers that have varying surface heights for dressing CMP polishing pads.

### SUMMARY OF THE INVENTION

In various embodiments of the invention, a pad conditioner machined from a substrate to have a desired distribution of feature heights and roughness characteristics is provided. The protrusions on the shaped substrate act as geometric features that provide force concentrations on the pad surface. In embodimeents first a substrate is produced having roughened or textured repeating protrusions, diamond grains are dispersed over the surface area and a layer of a polycrystalline CVD diamond coating that is grown over the surface protrusions and diamond grains. The roughness of the substrate facilitating securement of the diamond seed grains within the diamond coating to minimize or prevent dislodging.

In embodiments, the diamond grains being of a size that is less than the average thickness of the CVD coating measured in a direction extending away from the pad.

Features and advantages of embodiments of the invention are enhanced performance of the pad conditioner. In embodiments conditioner to conditioner cut rate repeatability is provided and consistent cut rate over the life of the conditioner, and reduced defects followed by the addition of diamond grit crystals onto the roughened surfaces and the addition of a CVD diamond layer wherein the diamond grit seed crystals are part of the matrix and the thickness of the CVD

In embodiments, silicon carbide segments having a roughened substrate with roughened protrusions formed thereon are first provided with small diamond seed grains (for example, diamond grit in the 1 nm to 30 nm diameter size range). Larger diamond grit seed crystals (for example, in the range from about 1 micormeter (µm) to about 12 µm range) can then be applied to the substrate and protrusions. A few milligrams of the large diamond grit can be applied to each segment. The large diamond grit adheres to the silicon carbide substrate and protrusions, with the roughened surface (for example, about 2 µm to about 5 µm RMS roughness) helps retain the larger diamond particles.

The addition of the larger diamond grit seed also allows the cut rate of the pad conditioner to be "tailored" over a wide range depending upon the size of the larger diamond grit seed crystals. "Larger" grit crystal sizes that are typically much less than the prior art utilization of grit that actually provided the cutting features. In embodiments, the grit is generally within the average thickness in the z-direction of the CVD coating. The textured surface helps retain the seed crystals, thereby abating the problem of particle dislodgement experienced with prior art pad conditioners. The seeded surfaces can then be coated with, for example, polycrystalline diamond.

### DESCRIPTION OF THE FIGURES

Figure 1 is a pictorial view of a wafer polishing apparatus with a pad conditioner.
Figure 2 is a perspective view of a pad conditioner assembly in accord with the inventions.
Figure 3 is a perspective view of a pad conditioner assembly in accord with the inventions.
Figure 4 is a photo image of a conditioner pad in accord with the inventions.
Figure 5 is a perspective image showing projections on a surface in accord with the inventions.
Figure 6a is a plan view of a projection array on a pad in accord with the inventions herein.
Figure 6b is a plan view of a projection array on a pad in accord with the inventions herein Figure 7 is a plan view of a projection array on a pad in accord with the inventions herein.
Figure 8 is a cross sectional view of a protrusion on a substrate with coatings in accord with the inventions herein.
Figure 9 is a chart showing experimental cut rates utilizing the inventions herein.
Figure 10 is a micrograph.
Figure 11 is a micrograph.
Figure 12 is a micrograph.
Figure 13 is a micrograph.
Figure 14 is a cross sectional view of a protrusion on a substrate with coatings in accord with the inventions herein.
Figure 15 is a cross sectional view of a protrusion on a substrate with coatings in accord with the inventions herein.

### DETAILED DESCRIPTION

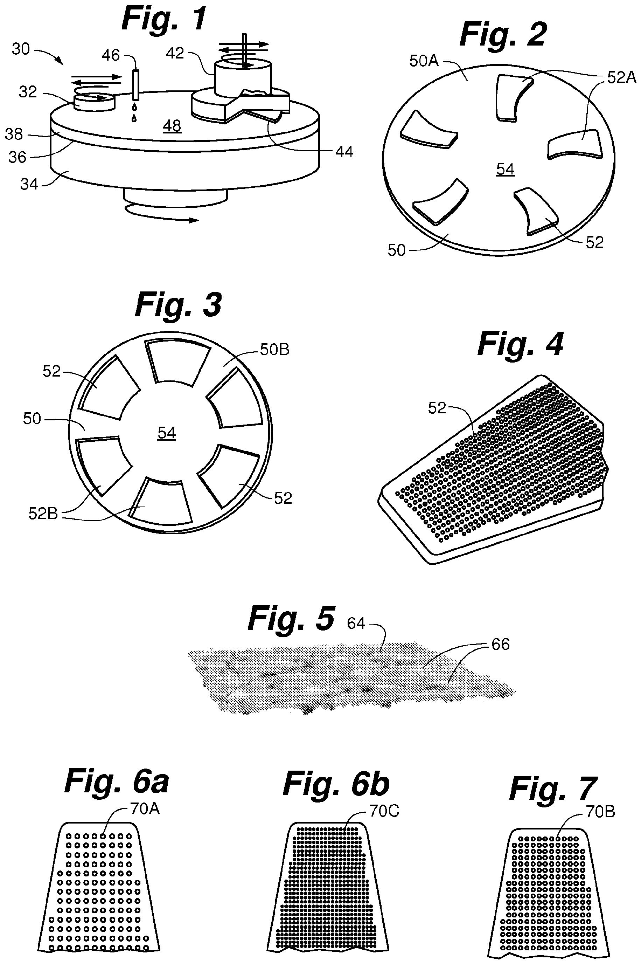

Referring now to FIG. 1, a wafer polishing apparatus 30 with a pad conditioner 32 in a chemical mechanical planarization (CMP) process is depicted in an embodiment of the invention. The depicted wafer polishing apparatus 30 includes a rotation table 34 having an upper face 36 with a CMP pad 38 (such as a polymeric pad) mounted thereon. A wafer head 42 having a wafer substrate 44 mounted thereon is arranged so that the wafer substrate 44 is in contact with the CMP pad 38. In one embodiment, a slurry feed device 46 provides an abrasive slurry 48 to the CMP pad 38.

In operation, the rotation table 34 is rotated so that the CMP pad 38 is rotated beneath the wafer head 42, pad conditioner 32 and slurry feed device 46. The wafer head 42 contacts the CMP pad 38 with a downward force F. The wafer head 42 can also be rotated and/or oscillated in a linear back-and-forth action to augment the polishing of the wafer substrate 44 mounted thereon. The pad conditioner 32 is also in contact with the CMP pad 38, and is translated back and forth across the surface of the CMP pad 38. The pad conditioner 32 can also be rotated.

Functionally, the CMP pad 38 removes material from the wafer substrate 44 in a controlled manner to give the wafer substrate 44 a polished finish. The function of the pad conditioner 32 is to remove debris from the polishing operation that fills the debris from the CMP process and to open the pores of the CMP pad 38, thereby maintaining the removal rate in the CMP process.

Referring to FIGS. 2 and 3, pad conditioner assemblies 50A, and 50b are depicted in embodiments of the invention. The pad assemblies (collectively referred to as pad assemblies 50) include conditioning segments 52a, 52b respectively (collectively referred to as conditioning segments 52), affixed to an underlying substrate or backing plate 54. The conditioning segments 52 can have protrusions of two or more different average heights, as discussed for various embodiments in WO 2012/1221186 A2, also PCT Patent Application No. PCT/US2012/027916. In one embodiment, the segments are bonded to the backing plate 54 using an adhesive such as an epoxy. FIG. 4 illustrates an individual segments. FIG. 5 illustrates an enlarged perspective view of a substrate surface 64 with protrusions 66 in a spaced pattern thereon formed by suitable machining in accord with the invention herein. FIGS. 6A, 6B, and 7 illustrate various densities of matrixical patterns 70A, 70B, and 70C suitable for the invention herein. "Matrix" when used herein may refer to a matrix with rows and columns or a circular matrix with circular rows expanding outwardly or portions thereof.

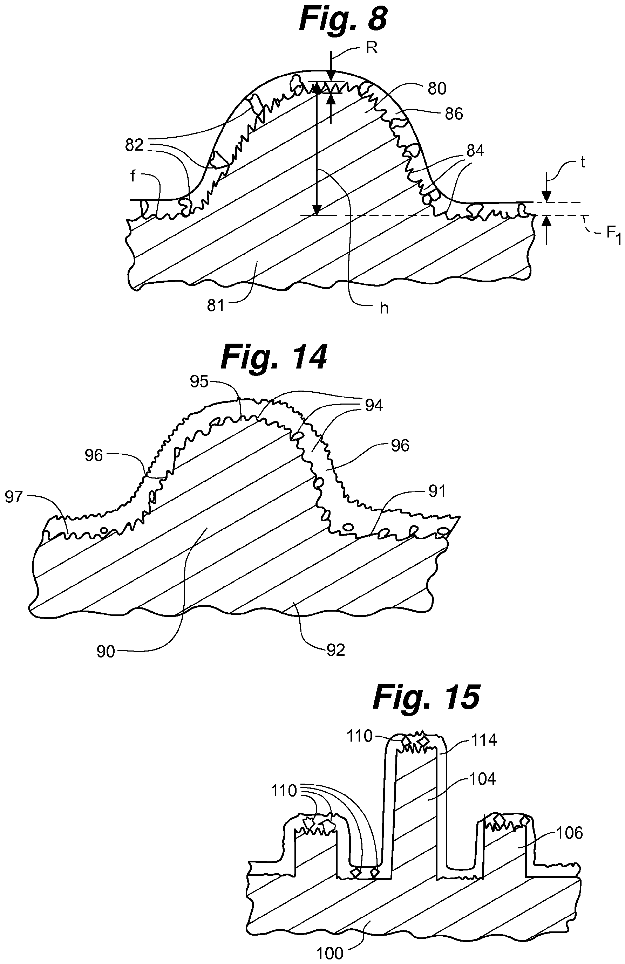

Referring to FIG. 8, a substrate 81, such as from one of the segments above, comprises a protrusion 80 having large diamond seed crystals 82 and small diamond seed crystals 84 seeded thereon and a polycrystalline diamond coating 86 thereover is depicted in an embodiment of the invention. The sectional view depicts the height h of the protrusions, the thickness t of the polycrystalline layer, and the roughness R of the substrate/protrusion material. The protrusion is characterized as having a height referenced from a floor level F of the substrate. To the exent the floor f is not uniform, the floor level may be considered the average of the lowest level between each adjacent protursion, the height of the protrusions may be measured from this average datum level.

In various embodiments, the thickness of the polycrystalline diamond layer can be about the diameter of the large diamond grit particles, as depicted in FIG. 8, or it can be larger in embodiments and in embodiment smaller. In various embodiments, the thickness of the polycrystalline diamond overlying the diamond grit seed and the surfaces ranges from about 50% to about 100% of the diameter of the large diamond grit size, the latter case of 100% of the grit size being depicted.

Functionally, the large diamond grit seed crystals add another dimension of roughness to the substrate and protrusion surfaces. The cut rate of the pad conditioner can advantageously be varied by choosing narrow size ranges for the large diamond grit seed crystals; narrow size ranges can be 1 µm, 2 µm, 4 µm, and up to about 6 µm.

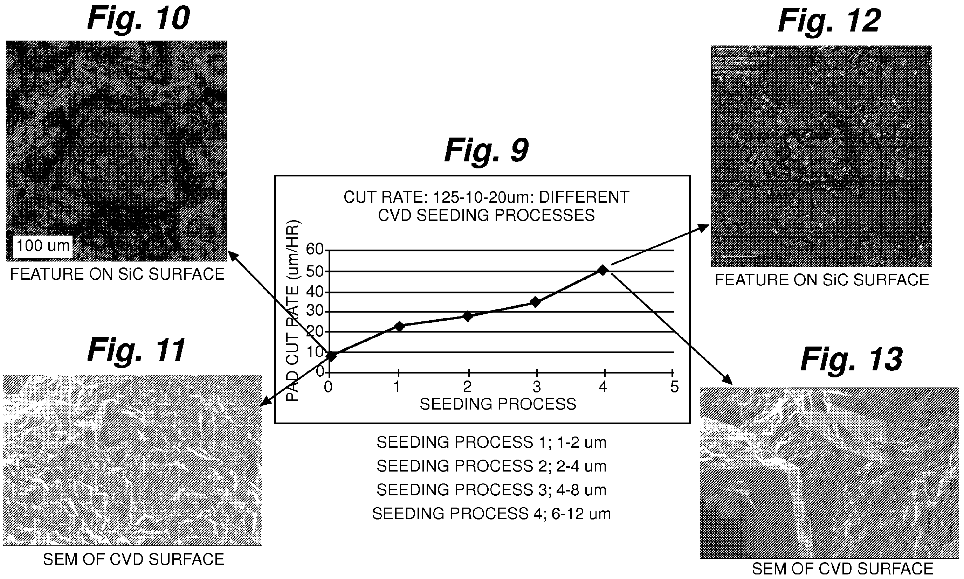

Referring to FIG. 9, performance metrics for a pad conditioner for varying large sized grit diameters is depicted in an embodiment of the invention. The data presented in FIG. 2 was for a conditioning pad having a 4 inch diameter with 5 segments coupled thereto. The features on the segments have a base dimension of 125 µm at a density of 10 features per square millimeter. The height of the features was nominally 20 µm. The pad cut rate using this conditioner was determined using a Buehler Ecomet 4 Benchtop Polisher. The pad used was an IC 1000 (TM) pad (Rohm and Haas) rotated at 50 rpm. The IC 1000 pad was contacted with the prototype pad conditioner with 7 lbs force and the rotation of the prototype pad conditioner was 35 rpm. Deionized water at a flow of 80 milliliters per minute was dispensed onto the pad during the cut rate experiment. The experiment was repeated with a new polishing pad having the large seed crystals, with diameters corresponding to the seeding process on the x-axis for FIG. 2.

The cut rate for a pad with large seed crystals in the range of 1 µm to 2 µm, (x-axis label 1) is about 23 µm per hour; for the 2 µm to 4 µm seed crystals (x-axis label 2) the cut rate is about 28 µm per hour; for the 4 µm to 8 µm seed crystals (x-axis label 3), the cut rate is about 32 µm per hour; and for 6-12 µm seed crystals the cut rate is about 50 µm per hour. The cut rate can also vary depending upon the type of pad conditioner. The point at "0 seeding" process in the graph corresponds to the case where only nanometer sized small diamond grit seed crystals are used (about 10 µm per hour cut rate).

FIG. 10 is a photograph of a protrusion without polycrystalline diamond (not the roughness). FIG. 11 is a photograph of a protrusion coated with polycrystalline diamond (with small nanometer sized seed crystals). FIG. 12 is a photograph of large diamond grit seed crystals on a protrusion and surfaces of a silicon carbide substrate having roughened surfaces. FIG. 13 is a photograph of polycrystalline diamond coating with larger diamond grit seed crystals, 6 to 12 microns, on a protrusion.

Example an non-limiting dimensions for the various aspects of FIG. 1 include: protrusion heights in the range of 10 to 150 µm; the polycrystalline diamond layer of about 7 to 15 µm average thickness with approximately 2 µm variation; the RMS roughness of the polycrystalline diamond coating can be from about 0.1 µm to about 2 µm; the roughness of the substrate, which can be silicon carbide, can be about 2 µm to about 5 µm. The protrusion features and their fabrication can be as described in Smith.

Referring to FIG. 14, a protrusion 90 having roughened or textured surfaces 91 on a rough base material 92 of a pad conditioner is depicted in an embodiment of the invention. The large diamond grit seed crystals 94 are interspersed on the roughened surface and in some cases the large diamond grit seed crystal in are substantially captured by the indentations or depressions that characterize the roughened surface. The large diamond seed crystals are shown on the "top" surface 95 of the protrusions, on the sides 96 of the protrusion, and in the channel 97 between protrusions. Advantageously the roughened surfaces of the protrusions helps to secure the large diamond grit seed crystals to part or all of the side surfaces, at least prior to the coating process. The roughness of the protrusions and substrate and the polycrystalline diamond coating atop the larger diamond grit seed also help to secure the diamond to the pad surface and reduces or eliminates loosening and loss of diamond crystals from the pad. The sides are typically form an obtuse angle measured between the channel region and incline. In embodiments the protrusion is rounded as illustrated. In embodiments the protrusion has a mesa or plateau, a flattened region rather than a rounded apex or peak.

Referring to FIG. 15, a portion of a pad conditioner, a substrate 100, having post shaped protrusions 104, 106 of differing heights, larger diamond grit seed crystals 110 on the surfaces of the substrate and protrusions of the pad conditioner, and a layer 114 of polycrystalline diamond that has a thickness that covers the large diameter sized diamond grit and surfaces of the conditioner. In one embodiment, the diameters of the larger grit seed crystals is in a range of diameters that is less than 6 µm. The polycrystalline diamond can be between 50% and 100% of the diameter of the larger diamond grit seed crystals. In embodiments, greater than 100%.

Smith, assigned to the assignee of the present application, discloses the use of pad conditioners having protrusions with surfaces that are roughened or textured and coated with CVD diamond material. The application of small diamond grit to surfaces for nucleating polycrystalline diamond films is disclosed by Malshe et al., Electrochemical Society Proceedings, Vol. 97-32 (1998), pp. 399-421 (ISBN 1-56677-185-4), disclosing the use of 4 nm sized diamond crystals as seeds. See also in U.S. Patent No. 4,925,701 to Jansen et al. (disclosing the implementation of 100 nm diamond seed) and U.S. Patent No. 5,474,808 to Aslam (disclosing the use of 25 nm seed).

As provided in the illustration, the pad cut rate and pad surface roughness are relatively steady for the pad conditioner of an embodiment of the invention compared to the commercial pad conditioners. The surface finish of an embodiment of the invention was also typically smoother than with the commercially available pad conditioner. The invention is defined by the appended claims.

## Claims

1. A chemical mechanical polishing pad conditioner (32), comprising: a substrate (81) including a front surface having a plurality of protrusions (80) integral therewith, said plurality of protrusions (80) extending in a frontal direction that is substantially normal to said front surface, each of said plurality of protrusions (80) including a distal extremity (h), and a dispersion of superabrasive grit seeds (82) disposed on said protrusions (80), the chemical mechanical polishing pad conditioner (32) being **characterized by**:
each of said plurality of protrusions (80) having a root-mean-square surface roughness (R) that is greater than 3 µm;
a dispersion of superabrasive grit seeds (82) disposed on said substrate (81); and
a diamond coating (86) that covers said substrate (81), said protrusions (80) and said dispersion of superabrasive grit seeds (82).

2. The chemical mechanical polishing pad conditioner (32) of claim 1, wherein the protrusions (80) of the substrate (81) have a matrixical arrangement, the projections each having a highest most peak (h), and each highest most peak positioned on its respective projection in a non repeating fashion with respect to the other projections.

3. The chemical mechanical polishing pad conditioner (32) of claim 1 wherein the protrusions (80) of the substrate (81) have repeating spacing pattern providing a density, the density being .5 to 5 projections per square mm.

4. The chemical mechanical polishing pad conditioner (32) of claim 1, wherein the protrusions (80) of the substrate (81) have a matrixical arrangement of projections (80) of a first height (h) and a matrixical arrangement of projections of a different height.

5. The chemical mechanical polishing pad conditioner (32) of claim 1, wherein said plurality of superabrasive diamond grit seeds (82) have diameters that range from about 1 µm to about 15 µm.

6. The chemical mechanical polishing pad conditioner of claim 1, wherein said plurality of superabrasive diamond grit seeds (82) have diameters that range from about 1 µm to about 15 µm and said coating (86) has a thickness (t) that is in the range of 50% to 100% of an average diameter of said superabrasive grit seeds (82).

7. The chemical mechanical polishing pad conditioner (32) of claim 5, further comprising a second plurality of superabrasive grit seeds (84) disposed on said surfaces of said substrate (81) and said protrusions (80), said second plurality of superabrasive grit seeds (84) having diameters that range from about 1 nm to about 30 nm.

8. The chemical mechanical polishing pad conditioner (32) of claim 3, wherein said substrate (81) and said protrusions (80) are of a silicon carbide material.

9. The chemical mechanical polishing pad conditioner (32) of any of the above claims wherein the substrate is mounted on a backing plate (54) and there are at least 4 additional like substrates.

10. A method of manufacturing a chemical mechanical polishing pad conditioner (32) according to claim 1, comprising providing a ceramic substrate (81), the method **characterized by**:
removing material from the silicon carbide substrate by machining to provide a repeating pattern of projections (80) each having a height of 10 to 150 microns, and having a root-mean-square surface roughness (R) that is greater than 3 µm;
dispersing a quantity of diamond grains (82) across on the substate (81);
coating the surface of the substate by chemical vapor deposition with diamond (86) thereby covering the projections (80) and the quantity of diamond grains (82).

11. The method of claim 10 further comprising selecting the quantity of diamond grains (82) to be substantially sized to be less than 12 microns.

12. The method of claim 10 further comprising selecting the quantity of diamond grains (82) to be substantially sized with a maximum diameter from 1 nm to 30 nm, and further selecting an additional quantity of diamond seed grains (84) to be sized to be greater than 2 microns and less than 12 microns, and further dispersing the additional quantity across the substrate (81).

13. The method of claim 10 further comprising selecting a silicon substrate (81) with a porosity of at least 10 per cent.

14. The method of any one of claims 10 through 13 further comprising providing a roughness to the silicon carbide of about 2 microns to about 5 microns before coating the surface with diamond (86).

15. The method of any of claims 10 through 13 further comprising providing a plurality of the ceramic substrates (52) and attaching them evenly spaced about a circular disk (54).

## Patentansprüche

1. Chemisch-mechanischer Polierpad-Konditionierer (32), umfassend: ein Substrat (81) mit einer vorderen Oberfläche mit einer Vielzahl von Überständen (80), die mit diesem einstückig sind, wobei sich die Mehrzahl von Überständen (80) in eine frontale Richtung erstreckt, die im Wesentlichen senkrecht zu der vorderen Oberfläche ist, wobei jeder der Vielzahl von Überständen (80) ein distales Ende (h) aufweist, und eine Dispersion aus superabrasiven Abriebkörnern (82), die auf den Überständen (80) angeordnet sind, wobei der chemisch-mechanische Polierpad-Konditionierer **gekennzeichnet ist durch**:
jeder der Vielzahl von Überständen (80) weist einen quadratischen Mittelwert einer Oberflächenrauheit (R) auf, der größer ist als 3 µm;
eine Dispersion aus superabrasiven Abriebkörnern (82), die auf dem Substrat (81) angeordnet sind; und
eine Diamantbeschichtung (86), die das Substrat (81), die Überstände (80) und die Dispersion aus superabrasiven Abriebkörnern (82) bedeckt.

2. Chemisch-mechanischer Polierpad-Konditionierer (32) nach Anspruch 1, wobei die Überstände (80) des Substrats (81) eine matrixförmige Anordnung aufweisen, wobei die Vorsprünge jeweils einen höchsten Peak (h) aufweisen und wobei jeder höchste Peak an seinem jeweiligen Vorsprung in einer sich nicht wiederholenden Weise in Bezug auf die anderen Vorsprünge positioniert ist.

3. Chemisch-mechanischer Polierpad-Konditionierer (32) nach Anspruch 1, wobei die Überstände (80) des Substrats (81) ein sich wiederholendes Abstandsmuster aufweisen, das eine Dichte bereitstellt, wobei die Dichte 0,5 bis 5 Vorsprünge pro Quadratmillimeter beträgt.

4. Chemisch-mechanischer Polierpad-Konditionierer (32) nach Anspruch 1, wobei die Überstände (80) des Substrats (81) eine matrixförmige Anordnung von Vorsprüngen (80) einer ersten Höhe (h) und eine matrixförmige Anordnung von Vorsprüngen unterschiedlicher Höhe aufweisen.

5. Chemisch-mechanischer Polierpad-Konditionierer (32) nach Anspruch 1, wobei die Vielzahl von superabrasiven Diamant-Abriebkörnern (82) Durchmesser aufweisen, die im Bereich von etwa 1 µm bis etwa 15 µm liegen.

6. Chemisch-mechanischer Polierpad-Konditionierer (32) nach Anspruch 1, wobei die Vielzahl von superabrasiven Diamant-Abriebkörnern (82) Durchmesser aufweisen, die im Bereich von etwa 1 µm bis etwa 15 µm liegen und die Beschichtung (86) eine Dicke (t) aufweist, die im Bereich von 50% bis 100% eines durchschnittlichen Durchmessers der superabrasiven Abriebkörner (82) liegt.

7. Chemisch-mechanischer Polierpad-Konditionierer (32) nach Anspruch 5, der weiterhin eine zweite Vielzahl von superabrasiven Abriebkörnern (84) umfasst, die auf den Oberflächen des Substrats (81) und der Überstände (80) angeordnet sind, wobei die zweite Vielzahl von superabrasiven Abriebkörnern (84) Durchmesser aufweist, die im Bereich von etwa von etwa 1 nm bis etwa 30 nm liegen.

8. Chemisch-mechanischer Polierpad-Konditionierer (32) nach Anspruch 3, wobei das Substrat (81) und die Überstände (80) aus einem Siliziumcarbid-Material sind.

9. Chemisch-mechanischer Polierpad-Konditionierer (32) nach einem der vorstehenden Ansprüche, wobei das Substrat an eine Montageplatte (54) montiert ist und dort mindestens 4 zusätzliche ähnliche Substrate sind.

10. Verfahren zur Herstellung eines chemisch-mechanischen Polierpad-Konditionierers (32) nach Anspruch 1, umfassend: Bereitstellen eines keramischen Substrats (81), wobei das Verfahren **gekennzeichnet ist durch**:
Entfernen von Material aus dem Siliziumcarbid-Substrat **durch** Bearbeiten, um ein sich wiederholendes Muster von Vorsprüngen (80) bereitzustellen, die jeweils eine Höhe von 10 bis 150 Mikrometer aufweisen und einen quadratischen Mittelwert einer Oberflächenrauheit (R) aufweisen, die größer ist als 3 µm;
Dispergieren einer Menge an Diamantkörnungen (82) auf dem Substrat (81);
Beschichten der Oberfläche des Substrats **durch** chemische Dampfphasenabscheidung mit Diamant (86), wodurch die Vorsprünge (80) und die Menge an Diamantkörnungen (82) bedeckt werden.

11. Verfahren nach Anspruch 10, weiterhin umfassend Auswählen der Menge an Diamantkörnungen (82), so dass sie im Wesentlichen eine Größe von weniger als 12 Mikrometer aufweisen.

12. Verfahren nach Anspruch 10, weiterhin umfassend Auswählen der Menge an Diamantkörnungen (82), so dass sie im Wesentlichen eine Größe mit einem maximalen Durchmesser von 1 nm bis 30 nm aufweisen, und weiterhin Auswählen einer zusätzlichen Menge an Diamantkornkörnungen (84), so dass sie eine Größe größer als 2 Mikrometer und weniger als 12 Mikrometer aufweisen und weiterhin Dispergieren der zusätzlichen Menge auf dem Substrat (81).

13. Verfahren nach Anspruch 10, weiterhin umfassend Auswählen eines SiliziumSubstrats (81) mit einer Porosität von weniger als 10 Prozent.

14. Verfahren nach einem der Ansprüche 10 bis 13, weiterhin umfassend Bereitstellen einer Rauhigkeit für das Siliciumcarbid von etwa 2 Mikrometer bis etwa 5 Mikrometer, bevor die Oberfläche mit Diamant (86) beschichtet wird.

15. Verfahren nach einem der Ansprüche 10 bis 13, weiterhin umfassend Bereitstellen einer Vielzahl der keramischen Substrate (52) und Befestigen derselben gleichmäßig beabstandet um eine kreisförmige Scheibe (54).

## Revendications

1. Un conditionneur (32) de tampon de polissage mécanique chimique, comprenant: un substrat (81) ayant une surface avant ayant une pluralité de saillies (80) solidaires de celui-ci, ladite pluralité de saillies (80) s'étendant dans une direction frontale qui est substantiellement perpendiculaire à ladite surface avant, chacune de ladite pluralité des saillies (80) ayant une extrémité distale (h), et une dispersion de grains (82) d'abrasion superabrasifs disposée sur lesdites saillies (80), le conditionneur (32) de tampon de polissage mécanique chimique étant **caractérisé par**:
chacune de ladite pluralité des saillies (80) ayant une rugosité (R) de valeur moyenne quadratique qui est supérieure à 3 µm;
une dispersion de grains (82) d'abrasion superabrasifs disposée sur ledit substrat (81); et
un revêtement (86) de diamant qui recouvre ledit substrat (81), lesdites saillies (80) et ladite dispersion de grains (82) d'abrasion superabrasifs.

2. Le conditionneur (32) de tampon de polissage mécanique chimique selon la revendication 1, dans lequel les saillies (80) du substrat (81) ont un arrangement matriciel, les proéminences ayant chacune un pic (h) le plus haut et chaque pic le plus haut étant positionné sur sa proéminence respective de manière non répétitive par rapport aux autres proéminences.

3. Le conditionneur (32) de tampon de polissage mécanique chimique selon la revendication 1, dans lequel les saillies (80) du substrat (81) ont un motif d'espacement répétitif fournissant une densité, la densité étant de 0,5 à 5 proéminences par mm carré.

4. Le conditionneur (32) de tampon de polissage mécanique chimique selon la revendication 1, dans lequel les saillies (80) du substrat (81) ont un arrangement matriciel de proéminences (80) d'une première hauteur (h) et un arrangement matriciel de proéminences d'une hauteur différente.

5. Le conditionneur (32) de tampon de polissage mécanique chimique selon la revendication 1, dans lequel ladite pluralité de grains (82) d'abrasion de diamant superabrasifs ont des diamètres qui vont d'environ 1 µm à environ 15 µm.

6. Le conditionneur (32) de tampon de polissage mécanique chimique selon la revendication 1, dans lequel ladite pluralité de grains (82) d'abrasion de diamant superabrasifs ont des diamètres qui vont d'environ 1 µm à environ 15 µm et ledit revêtement (86) a une épaisseur (t) qui va de 50% à 100% d'un diamètre moyen desdits grains (82) d'abrasion superabrasifs.

7. Le conditionneur (32) de tampon de polissage mécanique chimique selon la revendication 5, comprenant en outre une deuxième pluralité de grains (84) d'abrasion superabrasifs disposée sur lesdites surfaces dudit substrat (81) et desdites saillies (80), ladite deuxième pluralité de grains (84) d'abrasion superabrasifs ayant des diamètres qui vont d'environ 1 nm à environ 30 nm.

8. Le conditionneur (32) de tampon de polissage mécanique chimique selon la revendication 3, dans lequel ledit substrat (81) et lesdites saillies (80) sont en un matériau en carbure de silicium.

9. Le conditionneur (32) de tampon de polissage mécanique chimique selon l'une quelconque des revendications précédentes, dans lequel le substrat est monté sur une plaque (54) de fixation et au moins 4 substrats similaires supplémentaires sont là.

10. Un procédé de fabrication d'un conditionneur (32) de tampon de polissage mécanique chimique selon la revendication 1 comprenant fournir un substrat (81) en céramique; le procédé étant **caractérisé par**:
enlever le matériau du substrat en carbure de silicium par usinage pour fournir un motif répétitif de proéminences (80) ayant chacune une hauteur de 10 à 150 microns et ayant une rugosité (R) de valeur moyenne quadratique qui est supérieure à 3 µm;
disperser une quantité de grains (82) de diamant sur le substrat (81);
revêtir la surface du substrat par dépôt chimique en phase vapeur avec du diamant (86), couvrant ainsi les proéminences (80) et la quantité de grains (82) de diamant.

11. Le procédé selon la revendication 10, comprenant en outre sélectionner la quantité de grains (82) de diamant à dimension substantiellement inférieure à 12 microns.

12. Le procédé selon la revendication 10, comprenant en outre sélectionner la quantité de grains (82) de diamant ayant substantiellement une dimension ayant un diamètre maximal de 1 nm à 30 nm, et en outre sélectionner une quantité supplémentaire de grains (84) de diamant à une dimension supérieure à 2 microns et inférieure à 12 microns, et en outre disperser la quantité supplémentaire sur le substrat (81).

13. Le procédé selon la revendication 10, comprenant en outre sélectionner un substrat (81) de silicium ayant une porosité d'au moins 10 pourcent.

14. Le procédé selon l'une quelconque des revendications 10 à 13, comprenant en outre fournir une rugosité au carbure de silicium d'environ 2 microns à environ 5 microns avant de revêtir la surface avec du diamant (86).

15. Le procédé selon l'une quelconque des revendications 10 à 13, comprenant en outre fournir une pluralité de substrats (52) en céramique et fixer ceux-ci espacés uniformément autour d'un disque circulaire (54).
